Europäisches Patentamt

European Patent Office

Office européen des brevets

(11) Publication number: **0 055 582**
**B1**

# (12) EUROPEAN PATENT SPECIFICATION

(45) Date of publication of patent specification: **01.04.87**

(21) Application number: **81306024.1**

(22) Date of filing: **22.12.81**

(51) Int. Cl.⁴: **G 11 C 11/24**, G 11 C 11/34, G 11 C 11/40

(54) Memory circuit having a decoder.

(30) Priority: **29.12.80 JP 187955/80**

(43) Date of publication of application:
**07.07.82 Bulletin 82/27**

(45) Publication of the grant of the patent:
**01.04.87 Bulletin 87/14**

(84) Designated Contracting States:
**DE FR GB**

(56) References cited:
**US-A-3 803 554**

**IEEE TRANSACTIONS ON ELECTRON DEVICES, vol. ED-26, no. 6, June 1976, pages 886-892, IEEE, New York, US. K. KAWARADA et al.: "A 4K-bit static 12L memory"**

(73) Proprietor: **FUJITSU LIMITED**
**1015, Kamikodanaka Nakahara-ku
Kawasaki-shi Kanagawa 211 (JP)**

(72) Inventor: **Tanimoto, Kazuo
2-4-5-307, Suwa Tama-shi
Tokyo 206 (JP)**

(74) Representative: **Billington, Lawrence Emlyn et al
HASELTINE LAKE & CO Hazlitt House 28
Southampton Buildings Chancery Lane
London WC2A 1AT (GB)**

Courier Press, Leamington Spa, England.

## Description

This invention relates to a memory circuit having a decoder.

Generally, one-bit data are written into, and read from, a memory circuit in the following manner. First, n-bit binary address signals are supplied to a decoding circuit. Then the decoding circuit decodes the n-bit binary signals, thus enabling only that word line out of $2^n$ word lines which has been address-designated. Through the word line thus enabled one-bit data are supplied to or from the memory cell of the memory circuit.

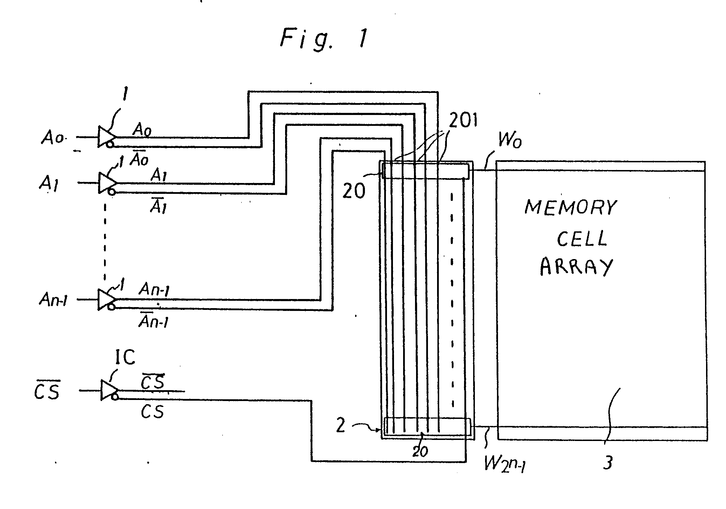

A previously proposed memory circuit is shown in Fig. 1. Binary address signals $A_0$, $A_1$, ... $A_{n-1}$ are supplied to address buffers 1. The address buffers 1 generate signals $A_i$ (i=0, 1, ... n−1) and signals $\bar{A}_i$ (i=0, 1, ... n−1) obtained by inverting the signals $A_i$, The signals $A_i$ and the signals $\bar{A}_i$ are supplied to decoder 2. The decoder 2 has output lines $W_j$ (j=0, 1, ... $2^n$−1) which are connected respectively to rows of memory cells constituting a memory cell array 3. Thus an output signal of the decoder 2 designates the cells of one row.

The decoder 2 comprises a plurality of decoding circuits 20 to which said output lines $W_j$ are connected, respectively. Each decoding circuit 20 is applied with signals at points 201 (indicated by black dots in the drawing). When all the binary address signals $A_i$ have a logic value "0" and thus designate 0th address, the word line $W_0$ of the decoder circuit 2 is enabled. In this case the decoder unit 20 functions as a NOR circuit.

The memory circuit further comprises a chip selection terminal $\overline{CS}$. The terminal $\overline{CS}$ is connected to a CS buffer 1C, whose inverted output signal CS is supplied to all the decoding circuits 20 of the decoder 2. Thus, when a chip selection signal $\overline{CS}$ is supplied to the chip selection terminal $\overline{CS}$, all the word lines $W_j$ are disabled and all the decoding circuits 20 are also disabled. As a result, no data can be written into, or read from, the memory cell array 3.

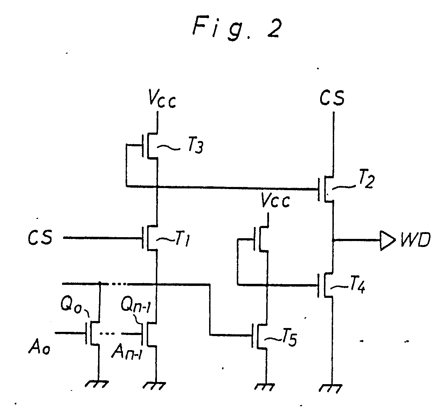

The circuitry of each decoding circuit 20 of the previously proposed decoder 2 is shown in Fig. 2. As shown in Fig. 2 the decoding circuit 20 comprises MOS transistors. It functions as a NOR circuit and supplies an output of a logic value "1" through its word line WD only when a chip selection signal CS has a logic value "1" and, at the same time, all the address signals $A_0$, $A_1$, ... $A_{n-1}$ have a logic value "0". More specifically, when transistors $Q_0$−$Q_{n-1}$ are off and a transistor $T_1$ is on, a transistor $T_2$ is turned on because its gate terminal receives a power source voltage $V_{cc}$ through a load MOS transistor $T_3$. Since the gate terminal of a transistor $T_4$ receives a low-level output of an inverting transistor $T_5$ which receives a high-level input signal and since the transistor $T_2$ is on, a chip selection signal CS of a logic level "1" appears in the word line WD. It follows that the decoding circuit 20 is selected and that the 0th address is designated.

Conversely, when at least one of the address signals $A_0$−$A_{n-1}$ has a logic value "1", the transistors $Q_0$, $Q_1$, ... or $Q_{n-1}$ which receives the address signal is turned on. As a result, the transistor $T_5$ is turned off and the transistor $T_4$ is turned on. In consequence current flows along a route constituted by the transistor $T_3$, the transistor $T_1$ and the transistor $Q_i$ (i=0, 1, ... or n−1) which is on. A chip selection signal CS of a logic value "0" therefore appears in the word line WD.

In the above-mentioned decoding circuit 20 current inevitably flows along the route made of $T_3$, $T_1$ and at least one transistor $Q_i$ (i=0, 1, ... or n−1).

In the previously proposed decoder 2, N−1 word lines out of N word lines corresponding to the total number N of memory words (N=$2^n$) are not selected and are kept at logic "0". Obviously there must flow within the decoder 2 an electric current which keeps the non-selected word lines at logic value "0". Hence the decoding circuit 20 consumes much power. In an existing static RAM, for instance, such a decoder uses up to about 35% of the power that the whole RAM consumes.

The IEEE Transactions on electron devices, Volume Ed-26, No. 6, June 1976, pages 886—92 discloses a word decoder for a memory as defined in the precharacterising part of claim 1.

According to the present invention there is provided a memory circuit having a memory cell array and a decoder comprising a plurality of decoder blocks, each block being comprised of a plurality of decoding circuits for selecting word lines, and said memory circuit comprising a means operable to generate block designating signals for selecting one of said plurality of blocks, whereby only one block to which a selected word line belongs will be rendered active in dependence upon address signals, characterised in that each decoding circuit comprises a plurality of transistors which are connected in parallel to receive address signals at their gates, a transistor which is to receive a block designating signal at its gate and is connected between a voltage source and said plurality of transistors, and a transistor connected in parallel with said plurality of transistors to receive the inverted signal of said block designated signal.

Accordingly, the present invention provides a memory circuit with a decoder which comprises a plurality of blocks and in which substantially no current is supplied to any block that is disabled, thereby reducing the power consumption.

For a better understanding of the present invention and to show how it may be put into effect reference will now be made by way of example to the accompanying drawings in which:

Fig. 1 is a block diagram of a memory circuit having a previously proposed decoder,

Fig. 2 is a circuit diagram of the decoding circuit of the memory circuit shown in Fig. 1;

Fig. 3A is a block diagram of a memory circuit having a decoder according to the present invention;

Fig. 3B is a circuit diagram of a driver circuit used in the memory circuit of Fig. 3A for driving the decoder thereof;

Fig. 4 is a circuit diagram of a possible decoding circuit for the memory circuit shown in Fig. 3A, this decoding circuit not being in accordance with the present invention; and

Fig. 5 is a circuit diagram of a decoding circuit according to the present invention.

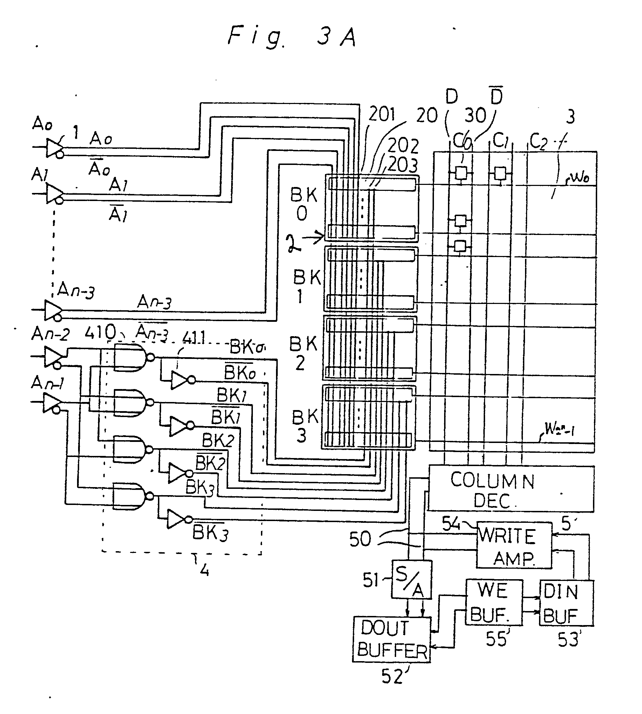

Fig. 3A shows an embodiment of a memory circuit according to the present invention. Binary address signals $A_0$, $A_1$, ... $A_{n-1}$ are supplied to address buffers 1. The address buffers 1 generate signals $A_i$ (i=0, 1, ... n-3) and signals $\overline{A}_i$ (i=0, 1, ... n-3) obtained by inverting the signals $A_i$. These signals $A_i$ and $\overline{A}_i$ are supplied to a NOR type decoder 2. The NOR type decoder has output lines $W_j$ (j=0, 1, ... $2^n-1$). The output lines $W_j$ are connected respectively to rows of memory cells constituting a memory cell array 3. Hence each output line $W_j$ designates the corresponding row of cells when it is enabled.

The NOR type decoder 2 comprises a plurality of decoding circuits 20 to which said output lines $W_j$ are connected, respectively. Each decoder unit 20 includes a group of inputs 201, and further inputs 202 and 203. When all the address signals $A_i$ have a logic value "0" and thus designate 0th address, the output line or word line $W_0$ is enabled and is turned to a logic value "1". In this case, therefore, the decoding circuit 20 functions as a NOR circuit.

In the read mode, when one of the word lines Wi (i=0 ... $2^{n-1}$), for example the word line $W_0$, is turned active and to the logic "1", content of all the memory cells 30 connected to the word line $W_0$ and aligned in a row direction in the memory cell array are inclined to read out through all of the bit lines D, $\overline{D}$. However, actually only one column, for example, column $C_0$ is designated by a column decoder 5 and thus, content of only the memory cell connected to the word line $W_0$ and connected to the bit lines D, $\overline{D}$ for column $C_0$ is outputted through a route of the output line 50 of the column decoder 5, sense amplifier 51 and data output buffer 52.

In the write mode, the data inputted through a data input buffer 53 and a write amplifier 54 is written in, for example, a memory cell connected to the word line $W_0$ activated by the decoder 2 and connected to a column $C_0$ designated by the column decoder 5. A write-enable buffer 55 controls the data input buffer 53 to form a write-enable condition and also controls the data output buffer circuit 52 to obtain the output data.

As shown in Fig. 3A, the decoder circuit 2 comprises four blocks 0 to 3, each of which is designated by two address signals $A_{n-1}$ and $A_{n-2}$. The address signals $A_{n-1}$ and $A_{n-2}$ are supplied to the address buffers 1. The address buffers 1 respectively generate two output signals $A_{n-1}$ and $A_{n-2}$ and two more output signals $\overline{A}_{n-1}$ and $\overline{A}_{n-2}$ obtained by inverting the signals $A_{n-1}$ and $A_{n-2}$. These four signals $A_{n-1}$, $A_{n-2}$, $\overline{A}_{n-1}$ and $\overline{A}_{n-2}$ are supplied to a two-bit decoder circuit 4. The two-bit decoder circuit 4 generates four signals $BK_0$, $BK_1$, $BK_2$ and $BK_3$ and four more signals $\overline{BK}_0$, $\overline{BK}_1$, $\overline{BK}_2$ and $\overline{BK}_3$ obtained by inverting the signals $BK_0$,

$BK_1$, $BK_2$ and $BK_3$, by using NOR circuits 410 and inverters 411. The signals $BK_0$ and $\overline{BK}_0$ are coupled to the decoding circuits 20 of the block 0 via their inputs 202 and 203. Similarly, the signals $BK_1$ and $\overline{BK}_1$ are coupled to the decoding circuits 20 of the block 1, the signals $BK_2$ and $\overline{BK}_2$ to the decoding circuits 20 of the block 2, and the signals $BK_3$ and $\overline{BK}_3$ to the decoding circuits 20 of the block 3.

When both most significant address signals $A_{n-1}$ and $A_{n-2}$ have logic "0", only the output signals $BK_0$ of the two-bit decoder circuit 4 among the output signals thereof $BK_0$, $BK_1$, $BK_2$, $BK_3$ has logic "1". Hence, the signals $\overline{BK}_0$ has logic value "0". As a result, all the decoding circuits 20 of the block 0 are enabled. Only one of the word lines of the block 0 which are designated by the lower significant address signals $A_0-A_{n-3}$ is enabled, whereby data may be written into, or read from, the memory cell which is designated by the word line thus enabled. In this case where the address signals $A_{n-1}$ and $A_{n-2}$ have logic value "0", the signals $BK_1$, $BK_2$ and $BK_3$ are inactive. Therefore, the word lines of the blocks 1, 2 and 3 are disabled and thus inactive. The current flowing to each block thus rendered inactive is extremely small, almost zero. More precisely, the current flowing to the decoding circuits 20 of each block in inactive state is reduced nearly to zero.

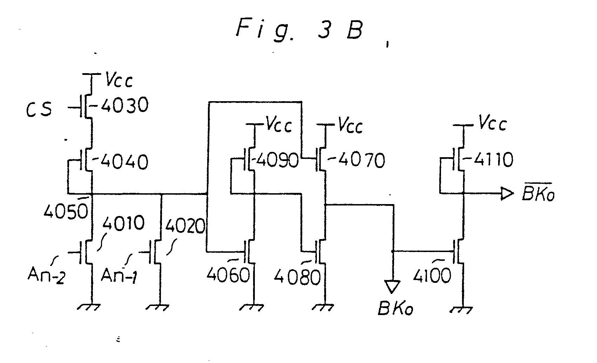

The detailed circuit diagram of the NOR circuit 410 and the inverter 411 in the decoder circuit 4 is shown in Fig. 3B, using MOS transistors.

Assume that the block designating signals $BK_0$ and $\overline{BK}_0$ should be outputted from the decoder circuit 4. The address signals $A_{n-1}$ and $A_{n-2}$ are inputted to the respective gates of the transistors 4010 and 4020. When at least one of the signals $A_{n-1}$ and $A_{n-2}$ is at the logic "1", either of transistors 4010 and 4020 is turned on. Then, if the chip select signal CS is at the logic "1", a transistor 4030 is turned on, thereby causing current to flow through a load transistor 4040. Thus, the cross point 4050 comes to the logic "0", thereby turning the transistors 4060 and 4070 off. As current does not flow through a load transistor 4090, the gate of a transistor 4080 comes up to a high level, i.e. logic "1", and is caused to turn on. Thus, the block designating signal $BK_0$ is turned to a low level, i.e. logic "0". Then as a transistor 4100 is turned off, the block designating signal $\overline{BK}_0$ is turned to logic "1".

If both of the address signals $A_{n-1}$ and $A_{n-2}$ inputted to the transistors 4010 and 4020 are at the logic "0", the transistors 4060 and 4070 are turned on as they have high level signals at their gates, causing the transistor 4080 to turn off. Thus, the block designating signal $BK_0$ comes to logic "1". At the same time the transistor 4100 is turned on, thereby causing the block designating signal $\overline{BK}_0$ to have a logic "0".

As described above, the block designating signal $BK_0$ is outputted as the output of the NOR circuit when the address input signals $A_{n-2}$ and $A_{n-1}$ are inputted thereinto. And the signal $\overline{BK}_0$ is reversed signal of the signal $BK_0$.

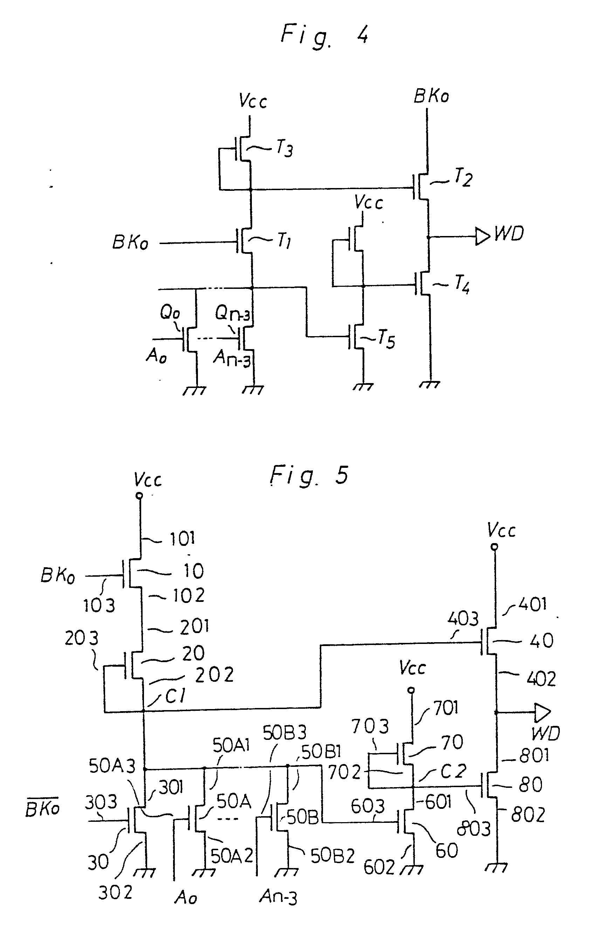

Fig. 4 shows a possible embodiment of each of the decoding circuits 20 used in the memory circuit shown in Fig. 3A. It must be emphasised that this embodiment is not in accordance with the present invention. In Fig. 4, like or the same numerals are used to denote like and the same elements as shown in Fig. 2 and are not described in detail. More precisely, the decoding circuit of Fig. 4 is one of the decoding circuits 20 of the block 0 of the memory circuit shown in Fig. 3A. The signal $BK_0$ which designates the block 0 is supplied to the gate of transistor $T_1$ and the drain of a transistor $T_2$. But the output signal $\overline{BK_0}$ of the decoder circuit 4 is notsupplied to this decoding circuit 20.

The decoding circuit 20 supplies an output of a logic value "1" through its word line WD only when the block designating signal $BK_0$ has a logic value "1" and, at the same time, all the address signals $A_0-A_{n-3}$ have a logic value "0". In this respect the decoding circuit 20 is similar to the decoding circuit 20 shown in Fig. 2. When at least one of the address signals $A_0-A_{n-3}$ has a logic value "1", the decoding circuit 20 supplies an output of a logic value "0" through its word line WD. Accordingly, the decoding circuit 20 functions as a NOR circuit.

As shown in Fig. 4, the drain of the transistor $T_2$ of the decoding circuit 20 shown in Fig. 4 is connected to a signal line for supplying the block designating signal $BK_0$ to the block 0. Therefore, when the word line WD (i.e. output line $W_0$ in Fig. 3A) is rendered active, the rising of the output signal is inevitably delayed and becomes unstable.

Fig. 5 shows a decoding circuit 20 according to the invention which eliminates the above-mentioned drawback of the decoding circuit 20 shown in Fig. 4. As shown in Fig. 5, this decoding circuit has a transistor 10 the gate 103 of which receives a block designating signal $BK_0$ and the drain 101 of which is connected to a voltage source $V_{cc}$, a transistor 20 the drain 201 of which is connected to the source 102 of the transistor 10 and the gate 203 and source 202 of which are connected to each other, and a transistor 30 the drain 301 of which is connected to the source 202 of the transistor 20, the source 302 of which is grounded and the gate 303 of which is coupled to receive a signal $\overline{BK_0}$ obtained by inverting the block designating signal $BK_0$. The decoding circuit further comprises a transistor 40 whose gate 403 is connected to the source 202 of the transistor 20, whose drain 401 is coupled to the voltage source $V_{cc}$ and whose source 402 is connected to a word line WD. The decoding circuit still further comprises a plurality of transistors 50A to 50B. To gates 50A3 to 50B3 of these transistor 50A to 50B address signals $A_0$ to $A_{n-3}$ are respectively applied. The drains 50A1 to 50B1 of the transistors 50A to 50B are connected commonly to the source 202 of the transistor 20, and the sources 50A2 to 50B2 are connected commonly to the ground.

The decoding circuit of Fig. 5 is further provided with a transistor 60 whose gate 603 is connected to the drains 50A1 to 50B1 of the n−2 transistors 50A to 50B and whose drain 601 is connected to the gate 703 and source 702 of a load MOS transistor 70, the drain of which is coupled to the voltage source $V_{cc}$. The source 602 of the transistor 60 is grounded. Still another transistor 80 is provided, whose gate 803 is connected to the drain 601 of the transistor 60, whose drain 801 is connected to a word line WD and whose source 802 is grounded.

As illustrated in Fig. 3A, the block 0 of the decoder 2 is comprised of a plurality of decoding circuits 20 which may be such ones as shown in Fig. 5. Each decoding circuit 20 of block i is connected to receive two block designating signals $BK_0$ and $\overline{BK_0}$. The logic values of these signals $BK_0$ and $\overline{BK_0}$ determine whether or not the block 0 is rendered active or selected. Hence, only those of the blocks 0 to 3 which are selected are operative and the non-selected blocks remain inoperative.

In the decoding circuit of Fig. 5, the block designating signal $BK_0$ is fed to the gate 103 of the transistor 10 and the reversed block designating signal $\overline{BK_0}$ to the gate 303 of the transistor 30. The word line WD of the decoding circuit is selected when all the word address signals $A_1-A_{n-3}$ are set to low level (i.e. logical value "0"), and at the same time, both address lines $A_{n-1}$ and $A_{n-2}$ have a logic value "0". Thus, when the word line WD is selected, the signal $BK_0$ is at a high level and the signal $\overline{BK_0}$ is at a low level, whereby 0th address of the block 0, i.e. word line $W_0$ is rendered active. Then, the transistor is turned on, and the transistors 30 and the n−2 transistors 50A—50B function as NOR circuits. As a result, no drain current flows in the transistor 10 or 20 and voltage of $V_{cc}$ appears at a node C1 and thus sets the node C1 to a high level. At this time a high-level voltage is applied to the gate 603 of the transistor 60, and current flows to the drain 601 of the transistor 60 through the load MOS transistor 70. In consequence, a high-level voltage is applied to the gate 403 of the transistor 40 and a low-level voltage is applied to the gate 803 of the transistor 80. The transistors 40 and 80 are thus turned on and off, respectively. An output of a logic value "1" is therefore supplied through the word line WD. As well understood from the above, as long as none of the word address lines WA is selected, no drain current flows through the transistor 60. This is why it is possible with a memory circuit according to embodiment of the present invention to reduce the power consumption.

Conversely, the block designating signal $BK_0$ has a low level and the block designating signal $\overline{BK_0}$ has a high level, when the block 0 is not selected. In this case, the word address lines WA are set to either a high level or a low level. And the transistor 10 is turned off, and no current flows through the transistor 10. As a result, the node C1 is set to a low level and the node C2 to a high level. An output of a logic value "0" is therefore supplied through the word line WD which is now set to a low level. If this is the case, the block 0 consumes no power.

The memory circuit is so designed that the block designating signal $BK_0$ is at a low level when a chip selection signal $\overline{CS}$ is at a high level. Hence, when the block designating signal $BK_0$ has a low level, the block 0 is put into "stand-by" state. That is, the block can be brought into "stand-by" state without using a chip selection signal CS or $\overline{CS}$.

As mentioned above, the present embodiment of the present invention is characterised in that the most significant binary address signals are used, instead of such chip selection signals as used in prior art, to provide block designating signals for designating a plurality of blocks which constitute a decoder, whereby the current flowing in any block not designated by a block designating signal is reduced substantially to zero.

An embodiment of the present invention can provide a memory circuit with a decoder which comprises a plurality of blocks and in which substantially no current is supplied to any block when the block is not designated.

If the decoder is constituted by two blocks, the block designating signals $BK_0$ and $\overline{BK}_0$ are generated from the most significant word address signals A. If the decoder is constituted by four blocks as shown in Fig. 3A, the block designating signal $BK_0$ may be a logical sum of the most significant word address $WA_{n-1}$ and the second most significant word address bit $WA_{n-2}$.

**Claims**

1. A memory circuit having a memory cell array (3) and a decoder (2) comprising a plurality of decoder blocks (BK), each block (BK) being comprised of a plurality of decoding circuits (20) for selecting word lines, and said memory circuit comprising a means (4) operable to generate block designating signals $(BK_i)$ for selecting one of said plurality of blocks (BK), whereby only one block (BK) to which a selected word line belongs will be rendered active in dependence upon address signals ($A_0$ etc), characterised in that each decoding circuit (20) comprises a plurality of transistors (50A to 50B) which are connected in parallel to receive address signals at their gates, a transistor (10) which is to receive a block designating signal $(BK_0)$ at its gate and is connected between a voltage source $(V_{cc})$ and said plurality of transistors (50A to 50B), and a transistor (30) connected in parallel with said plurality of transistors (50A to 50B) to receive the inverted signal $(\overline{BK}_0)$ of said block designating signal $(BK_0)$.

2. A memory circuit according to claim 1, wherein in said decoding circuit (20) there is provided a transistor (20) connected between said transistor (10), which is to receive said block designating signal $(BK_0)$, and said plurality of transistors (50A to 50B), the gate of this transistor (20) being connected to the point of connection (C1) between this transistor (20) and said plurality of transistors (50A to 50B), and the decoding circuit also comprising an output word line (WD) coupled to a voltage source $(V_{cc})$ by a transistor (40) having its gate connected to said point of connection (C1).

3. A memory circuit according to claim 2, wherein said decoding circuit (20) further comprises a transistor (80) connected between said output word line (WD) and earth, and a pair of further transistors (70, 60) connected between a voltage supply $(V_{cc})$ and earth, the gate of a first transistor (70) of this pair of transistors being coupled to the interconnection (C2) between the pair; and also to the gate of the transistor (80) connected between said output word line (SD) and earth, and the gate of the second transistor (60) of said pair being coupled to said point of connection (C1).

4. A memory circuit according to any preceding claim, wherein the transistors are MOS transistors.

**Patentansprüche**

1. Speicherschaltung mit einer Speicherzellenanordnung (3) und einem Decoder (2), der eine Vielzahl von Decoderblöcken (BK) umfaßt, wobei jeder Block (BK) aus einer Vielzahl von Decoderschaltungen (20) zur Auswahl von Wortleitungen besteht, und die genannte Speicherschaltung eine Einrichtung (4) umfaßt, die betreibbar ist, um Blockbestimmungssignale $(BK_i)$ zur Auswahl einer der genannten Vielzahl von Blöcken zu erzeugen, wodurch nur ein Block (BK), zu dem die ausgewählte Wortleitung gehört, in Abhängigkeit von Adressensignalen ($A_0$ etc) aktiv gemacht wird, dadurch gekennzeichnet, daß jede Decoderschaltung (20) eine Vielzahl von Transistoren (50a bis 50B) umfaßt, die parallel angeschlossen sind, um an ihren Gates Adressensignale zu empfangen, einen Transistor (10), der ein Blockbestimmungssignal $(BK_0)$ an seinem Gate empfängt und zwischen einer Spannungsquelle $(V_{cc})$ und der genannten Vielzahl von Transistoren (50A bis 50B) angeschlossen ist, und einen Transistor (30), der parallel mit der genannten Vielzahl von Transistoren (50A bis 50B) verbunden ist, um das invertierte Signal $(\overline{BK}_0)$ des Blockbestimmungssignals $(BK_0)$ zu empfangen.

2. Speicherschaltung nach Anspruch 1, bei der in der genannten Decoderschaltung (20) ein Transistor (20) vorgesehen ist, der mit dem genannten Transistor (10), der das genannte Blockbestimmungssignal $(BK_0)$ empfangen soll, und der genannten Vielzahl von Transistoren (50a bis 50B) verbunden ist, wobei das Gate dieses Transistors (20) mit dem Verbindungspunkt (C1) zwischen diesem Transistor (20) und der genannten Vielzahl von Transistoren (50A bis 50B) verbunden ist, und die Decoderschaltung ferner eine Ausgangswortleitung (WD) umfaßt, die mit einer Spannungsquelle $(V_{cc})$ über einen Transistor (40) gekoppelt ist, dessen Gate mit dem genannten Verbindungspunkt (C1) verbunden ist.

3. Speicherschaltung nach Anspruch 2, bei der die Decoderschaltung (20) ferner einen Transistor (80) umfaßt, der zwischen der genannten Ausgangswortleitung (WD) und Erde verbunden ist, und ein Paar von weiteren Transistoren (70, 60), die zwischen einer Spannungsversorung ($V_{cc}$) und Erde verbunden sind, wobei das Gate des ersten Transistors (70) dieses Paares von Transistoren mit der Verbindung (C2) zwischen dem Paar gekoppelt ist, und ferner mit dem Gate des Transistors (80), der zwischen der genannten Ausgangswortleitung (SD) und Erde verbunden ist, und das Gate des zweiten Transistors (60) des genannten Paares mit dem genannten Verbindungspunkt (C1) gekoppelt ist.

4. Speicherschaltung nach einem der vorhergehenden Ansprüche, bei der die Transistoren MOS-Transistoren sind.

**Revendications**

1. Circuit de mémoire comprenant une matrice de cellules de mémoire (3) et un décodeur 2 constitué par plusieurs blocs décodeurs (BK), chaque bloc (BK) étant constitué par plusieurs circuits de décodage (20) pour sélectionner des lignes de mots et ledit circuit de mémoire comportant un dispositif (4) ayant pour fonction de produire des signaux de désignation de bloc ($BK_i$) afin de sélectionner l'un desdits plusieurs blocs (BK) de manière qu'un seul bloc (BK) auquel appartient une ligne de mots sélectionné soit rendu actif en fonction de signaux d'adresse ($A_0$), etc, Caractérisé en ce que chaque circuit de décodage (20) comporte plusieurs transistors (50A à 50B) qui sont connectés en parallèle pour recevoir des signaux d'adresse à leurs grilles, un transistor (10) qui reçoit un signal de désignation

de bloc ($BK_0$) à sa grille et qui est connecté entre une source de tension ($V_{cc}$) et lesdits plusieurs transistors (50A) à (50B) et un transistor (30) connecté en parallèle avec lesdits plusieurs transistors (50A à 50B) pour recevoir le signal inversé ($\overline{BK_0}$) dudit signal de désignation de block ($BK_0$).

2. Circuit de mémoire selon la revendication 1, dans lequel, dans ledit circuit de décodage (20) est prévu un transistor (20) connecté entre ledit transistor (10) qui reçoit ledit signal de désignation de bloc ($BK_0$), et lesdits plusieurs transistors (50A à 50B) la grille de ce transistor (20) étant connectée au point de connexion (C1) entre ce transistor (20) et lesdits plusieurs transistors (50A à 50B) et le circuit de décodage comportant en outre une ligne de mots de sortie (WD) reliée à une source de tension ($V_{cc}$) par un transistor (40) dont la grille est connectée audit point de connexion (C1).

3. Circuit de mémoire selon la revendication 2, dans lequel ledit circuit de décodage (20) comporte en outre un transistor (80) connecté entre ladite lignes de mots de sortie (WD) et la masse et une paire d'autres transistors (70, 60) connectés entre une source de tension ($V_{cc}$) et la masse, la grille d'un premier transistor (70) de cette paire de transistors étant reliée à l'interconnexion (C2) entre la paire et également à la grille du transistor (80) connecté entre ladite ligne de mots de sortie (SD) et la masse et la grille du second transistor (60) de ladite paire étant reliée audit point de connexion (C1).

4. Circuit de mémoire selon l'une quelconque des revendications précédentes, dans lequel les transistors sont des transistors MOS.

## Fig. 1

## Fig. 2

Fig. 3A

Fig. 3 B

# Fig. 4

# Fig. 5